(19) **Europäisches Patentamt / European Patent Office / Office européen des brevets**

(11) **EP 3 256 314 B1**

(12) **EUROPEAN PATENT SPECIFICATION**

(45) Date of publication and mention
of the grant of the patent:
**26.08.2020 Bulletin 2020/35**

(21) Application number: **16707563.9**

(22) Date of filing: **15.02.2016**

(51) Int Cl.:
**B32B 7/12** *(2006.01)* **B32B 21/02** *(2006.01)*
**B32B 21/06** *(2006.01)* **B32B 29/00** *(2006.01)*
**B32B 29/06** *(2006.01)* **B32B 38/04** *(2006.01)*
**B32B 38/10** *(2006.01)* **B32B 38/00** *(2006.01)*
**H05K 1/00** *(2006.01)*

(86) International application number:
**PCT/IB2016/050804**

(87) International publication number:
**WO 2016/128953 (18.08.2016 Gazette 2016/33)**

(54) **WOOD DERIVED MULTILAYER PRODUCT WITH INTEGRATED ELECTRIC CIRCUIT AND MANUFACTURING PROCESS**

MEHRSCHICHTIGES PRODUKT AUS HOLZ MIT INTEGRIERTER ELEKTRISCHER SCHALTUNG UND HERSTELLUNGSVERFAHREN

PRODUIT MULTICOUCHE DÉRIVÉ DU BOIS AVEC CIRCUIT ÉLECTRIQUE INTÉGRÉ ET PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.02.2015 PT 15108227**

(43) Date of publication of application:
**20.12.2017 Bulletin 2017/51**

(73) Proprietors:
• **CENTITVC - Centro de Nanotecnologia e Materiais Tecnicos, Funcionais e Inteligentes**
4760-034 Vila Nova de Famalicão (PT)
• **Sonae - Indústria de Revestimentos, S.A.**
4471-909 Maia (PT)

(72) Inventors:
• **CARVALHO GOMES, João Manuel**
4700-832 Ruílhe (PT)
• **DINIZ DA FONSECA, Joana**
4425-642 Pedrouços - Maia (PT)
• **PINTO LOPES, Jaime Rafael**
4460-080 Guifões (PT)
• **SILVESTRE MENDES PINTO DE MOURA, Bruna Gabriela**
4760-292 Vila Nova de Famalicão (PT)
• **POÇAS GONÇALVES, José Joaquim**
4710-432 Braga (PT)

• **BASTOS DA SILVA, Miguel António**
Sanfins Vfr (PT)
• **ROCHA FELGUEIRAS DE SOUSA NOGUEIRA, Miguel**
4450-732 Leça da Palmeira (PT)
• **DE MELO MAIA, Cristina Isabel**
4715-319 Braga (PT)
• **RIBEIRO DA CRUZ, Paulo Jorge**
4905-204 Alvarães - Viana Do Castelo (PT)
• **MACIAS FERRA, João Miguel**
4410-108 São Félix da Marinha - Vila Nova de Gaia (PT)
• **FARIA RAMOS TAVARES, Neuza Patrícia**
4410-151 São Félix da Marinha - Vila Nova de Gaia (PT)
• **PACHECO NEVES CARTEADO MENA, Pedro Miguel**
Leça Da Palmeira, 4450-349 (PT)

(74) Representative: **Patentree**
Edificio Net
Rua de Salazares, 842
4149-002 Porto (PT)

(56) References cited:
**WO-A1-00/45353          WO-A1-89/03760**
**DE-U1-202014 003 058**

Remarks:
The file contains technical information submitted after the application was filed and not included in this specification

Remarks:
The file contains technical information submitted after the application was filed and not included in this specification

## Description

## Technical field

The present disclosure refers to wood derived multilayer products, profiles, framed, laminate or compact products, among others, with integrated electric circuits, for example capacitive sensors, and the fabrication process thereof.

## Background

PT1536065E describes a decorative paper for use in a floor panel surface with application of quaternary ammonium compounds in a mixture of resin. The resin can be urea or melamine resin, and the mixture can also include abrasion resistant particles, such as corundum. Said mixture, applied to the paper, gives it antistatic properties, so that when it is used in flooring panels, there is a reduction of static electricity generated by people when they walk on the panels. US2003136494A1 describes a floor plank, multi-layer, of laminate pressed panels, that comprises on the superior part a decorative paper, on the layer that is intended to be walked on, which is impregnated with aminoplastic resins or similar. The particles of an electricity conductive material are applied on the back of the decorative paper. GB572267 describes a laminate for similar uses to that of wood, with a reinforcing core of textile strings and metal wires. The core is joined to the veneers via a synthetic resin, with the help of heat and pressure. The veneers or the textile can be impregnated with resin, for example, a denatured alcohol solution of a phenol resin or urea-aldehyde. The resin can be applied to a sheet of fabric paper inserted between the fabric and the veneers. Vinyl resins can be used. The general technical background of the invention also includes DE20 2014 003 058 U1.

These facts are disclosed in order to illustrate the technical problem addressed by the present disclosure.

## Summary

The invention is defined in the appended claims. The disclosure includes a wood derived multilayer glued or laminated product having an integrated electric circuit, comprising a paper layer and conducting elements of conductive ink deposited on said paper layer, said elements being suitable for forming an electric circuit and said paper layer has rugosity (i.e. roughness) inferior to 60 μm, wherein the product is obtained by:

> depositing conductive ink on the paper layer, in a roll or sheet by sheet, to form said electric circuit including conducting elements;
> arranging the paper layer with at least one electric circuit under at least one further paper layer; pressing the paper layers together with the electric circuit paper layer.

In order to preserve a flat top surface of the final product, a low rugosity of the paper layer is important. However, if the rugosity is too low, the adhesion of the conductive ink is impaired. Preferably, the rugosity is between 20 μm and 50 μm.

Rugosity is measured by stylus profilometer using Average Roughness Ra (raw) - which is the arithmetic average of the absolute values of the profile height deviations recorded within the evaluation length (L) and measured from the mean line:

$$Ra = (|Z1| + |Z2| + |Z3| \ldots |ZN|)/N.$$

The evaluation lengths are the lengths of the areas where the conducting elements of conductive ink are to be deposited, i.e. lengths over substantially all the area where the conducting elements of conductive ink are to be deposited. However, measuring the rugosity over a representative length of the area where the conducting elements of conductive ink are to be deposited is enough, because paper rugosity is a substantially uniform characteristic of paper and it is well known how to control for this uniformity.

Rugosity (i.e. roughness) was measured using stylus profilometer KLA TENCOR D-100.

The thickness of the conductive elements of deposited conductive ink should preferably not be higher than 20 μm in order to keep unchanged the surface appearance of the multilayer product, for example, causing saliencies on the surface of the product.

In order to preserve a flat top surface of the final product, the relationship between the thickness of the conductive elements of deposited conductive ink and the rugosity (i.e. roughness) of the paper layer is also important, namely a relationship of substantially of 1 to 3.

For printed layers or films with the thickness equal or below 20 μm, the rugosity (i.e. roughness) of the paper to be printed should be less than 60 μm in order to obtain printed layers or films without electrical discontinuities.

The paper layer receiving deposited conductive elements is made of kraft paper.

Kraft paper has shown to be capable of accommodating the thickness of the deposited elements thus preserving a flat top surface of the final product.

Also, when the product comprises a fibreboard substrate and only a paper layer of decorative paper layer glued onto said substrate, it is advantageous that the conducting elements are deposited on the face of the decorative paper layer facing the substrate, and not the substrate, which is better at accommodating the thickness of the deposited elements thus preserving a flat top surface of the final product. This may also be explained by said rugosity of the paper layer.

The present disclosure describes a wood derived multilayer product with integrated sensors and electric circuits comprising a paper layer, with rugosity (i.e. roughness) inferior to 60 $\mu$m and resistance to 80°C temperatures, upon which a conductive ink is deposited in conductive elements forming an electric circuit or sensor.

In an embodiment, the rugosity of the paper layer used in the multilayer product is comprised between 20 $\mu$m and 50 $\mu$m.

In another embodiment, the paper layer of the multilayer product is resistant to 200°C temperature.

In another further embodiment, the electric circuit of the multilayer product comprises capacitive or resistive sensors of proximity detection at its surface and/or presence of objects and/or presence of water.

In an embodiment, the capacitive sensor of the multilayer product is composed of one or two interdigitated electrodes.

In another embodiment, the electrode used on the capacitive sensor of the multilayer product presents the form of intercalated combs or fingers.

In another further embodiment, the multilayer product comprises at least an additional paper layer placed on or under the paper layer containing the electric circuit.

In an embodiment, the multilayer product comprises at least a hole in the paper layer for the passage of electric connections to the conductive elements of the electric circuit.

In another embodiment, the multilayer product comprises the integration of light emitters.

In another further embodiment, the electronics of the multilayer product are connected to the printed sensor by clamping of a metallic connector onto an end of the sensor.

In an embodiment, the multilayer product comprises a recess for accommodating the electronic control unit.

In another embodiment, the multilayer product comprises electric components of the electric circuit on the paper layer of the electric circuit, clamped on the conductive elements.

In another further embodiment, the multilayer product comprises a decorative paper layer on the layer or layers of paper.

The paper used in the multilayer product is kraft paper. The kraft paper may be plain kraft paper, impregnated kraft paper, or kraft paper impregnated with phenolic resin.

In another embodiment, the conductive ink used in the multilayer product is of solvent base, aqueous base, or oily base.

In another further embodiment, the conductive ink used in the multilayer product contains at least a conductive material and/or polymeric material.

In an embodiment, conductive ink used in the multilayer product contains silver and/or copper and/or carbon and/or graphite and/or platinum and/or PEDOT:PSS.

In another embodiment, the resistive sensor used in multilayer product is constituted by carbon or ceramic films with a positive temperature coefficient.

In another further embodiment, the multilayer product is a compact, laminate, profile or framed product.

The present disclosure further describes the fabrication process of wood derived multilayer product with an integrated electric circuit, which comprises the following steps:

- providing a paper layer having rugosity inferior to 60 $\mu$m;
- depositing conductive ink on said paper layer, in a roll or sheet by sheet, forming an electric circuit including conductive elements;
- arranging the paper layer with at least one electric circuit under at least one further paper layer;
- incorporating, by gluing or laminating, said electric circuit paper layer into the multilayer product by pressing the paper layers together with the paper layer with electric circuit;

wherein the paper used in the multilayer product is kraft paper.

The printed circuit may be connected by clamping onto the electronics.

In an embodiment, the fabrication process of the multilayer product further comprises the integration step of the light emitters on wood derived products, comprising the following steps:

- depositing conductive tracks on paper, the track being for example able to constitute conductive matrices;
- placing light emitters through an automatic or manual system of component placing;
- arranging the paper layer with conductive tracks/matrices and integrated light emitters on or under one or several paper layers;
- drilling/cutting out the subjacent papers, in order to compensate for the relief caused by integrated light emitters;
- pressing the paper layers together with the paper layer with conductive tracks/matrices and integrated light emitters;
- connecting the printed track by clamping onto the electronics.

In another embodiment, the conductive ink used in the fabrication process of the multilayer product is deposited by printing, offset printing, rotogravure, serigraphy, flexography, rotary serigraphy, inkjet or spraying.

In another further embodiment, the fabrication process of the multilayer product comprises the clamping of electric components on the said conductive elements, on or under the paper layer of the electric circuit.

## General Description

The present disclosure refers to wood derived multilayer products, profiles, framed, laminate or compact products, among others, with integrated sensors and electric circuits, and fabrication process thereof.

Advantageously, the disclosure does not alter the superficial appearance of these products, namely its flatness, and does not require significant changes to the machinery used in its manufacture process.

The manufacture process of wood derived products having printed electric circuits in paper, or impregnated paper with resin, normally require high pressure and temperature conditions for the development of the final wood profile, wood derived, laminate and compact products.

The products described in this disclosure, together with all the electronics for acquisition, processing and control of signals read by sensor systems, have an improved usefulness, without changing the superficial aspect, main mechanical properties and of the durability of the wood derived products.

It is important that the electric circuit integration process is compatible and withstands the conditions of processing and fabrication of these products.

The solution described herein can be integrated in laminate and/or compact products, used, for example, in furniture or floor coating, as well as wood profiles and/or framed products, for example skirting boards, door and window frames, floor profiles, door coatings, cabinets and/or tables, furniture in general, floor coatings or wall coatings.

The present solution is particularly useful for the detection of floods; for products activated by touch, for example with light emission, sound emission, or another previously defined output, like for example the counting of steps at the entrance of buildings; for products with fully integrated light emitters and which are not visible, without changing their original appearance. The sensors allow for the functionalization of the pieces wherein they are integrated in, since, for being for example sensitive to the presence of water and/or touch, together with the necessary electronics, they allow, for example, the parts to detect floods or activate a given predefined exit.

The present disclosure relates to wood derived multilayer products, profiles, framed, laminate or compact products, among others, with sensors and electric circuits that include conductive elements, wherein said conductive elements are of conductive ink deposited on one of the paper layers.

The printing ink contains conductive materials, for example silver, copper, nickel, carbon, graphite, platinum, polymeric conductive materials, like for example poly(3,4- ethylenedioxythiophene) doped polystyrene sulphonate, commonly named as PEDOT:PSS. The conductive ink can be of solvent base, aqueous base, or oily base.

In the sensor printing process, printing techniques like serigraphy, rotogravure, spraying, flexography, rotary serigraphy, printing by ink jet (inkjet) and/or offset printing are, among others, possible. The printed sensors can be of the capacitive sensor or resistive sensor type or others that can be printed.

In an embodiment, the capacitive sensor is formed by an electric circuit composed of two interdigitated electrodes, for example with the form of a comb or intercalated fingers, or by two electrodes with the form of a nucleus and a ring, and can be formed according to a pre-defined geometric shape, the ring being around the nucleus, or of only one electrode.

In an embodiment, said electric circuit comprises capacitive electrodes to detect touch or proximity to its surface and/or the presence of objects and/or the presence of water in its proximity.

Resistive sensors also can be used, which are based on variations of resistance, being used for namely detecting physical quantities variations like temperature, pressure and the concentration of a particular substance. These sensors include at least two electrodes which can also be printed. In an embodiment, resistive sensors are also constituted by functional materials which can be processed by printing techniques, as is the case of some carbon films or PTC ceramics (Positive Temperature Coefficient) so that the sensor itself is printed together with the electric circuit.

Kraft paper is a type of paper manufactured from a mixture of long and short cellulose fibres, originating from soft wood pulps. This mixture of fibres provides mechanical resistance characteristics with a good processing performance on machines and a relative softness.

The paper may be recoated with paraffin or also laminate with polymers, eg. plastic resins, particularly recoated or laminate with heat, provided that it retains its adhesive characteristics, mechanical resistance and softness for the described embodiments.

The paper should exhibit properties adequate to the printing process, namely superficial rugosity not superior to 60 $\mu$m, preferably comprised in the range between 20 $\mu$m and 50 $\mu$m and withstanding temperatures superior to 80 °C, preferably between 80 and 200 °C, without losing the adequate characteristics necessary to the underlying processes.

Different resin content and/or a prolonged exposure of the paper to high temperatures (superior to 100° C) can provoke an accentuated loss of moisture, making it brittle, lacking the resin content suited for the fabrication process. Therefore, their use could compromise the final characteristics of the product. As such, the temperatures and exposure times of paper for curing the printing ink should be controlled.

Taking into consideration the values of rugosity and curing conditions (time and temperature), the amount of printed ink per unit of area shall be adjusted according to the specificity of the paper so that the response obtained from the sensor will not be compromised.

In an embodiment, the circuit is printed on impregnated kraft paper, constituting a multilayer structure, comprising one or more additional paper layers on or under the paper layer of the electric circuit which will be pressed, according to very high pressure and temperature conditions, for the formation of laminate and/or compact products.

One of the main differences between laminate and compact products is in the thickness of the final product, the laminate products being normally produced in thicknesses up to 2 mm and compact products having thicknesses above 2 mm.

In this embodiment, said additional layers comprise at least a hole for the passage of electric connections to the conductive elements of said electric circuit.

This disclosure further describes the integration of light emitters, such as LEDs, in wood derived products with integrated sensorisation. These light emitters can be activated by touch or proximity, or another that is meant to be defined, to the integrated sensor.

For multilayer products with light emitters these are integrated almost invisibly, without significant change in the original appearance of the wood derived product. LEDs of small dimensions are integrated by printing conductive tracks on paper, the tracks being for example able to constitute conductive matrices.

In an embodiment, in case the wood derived products are laminate or compact products, a perforation/snip of the subjacent papers is made so that the component can withstand higher pressures. After being subjected to pressing, the final appearance is identical to a laminate and/or compact product without an integrated light emitter.

The paper is kraft paper. The light emitters can be placed preferably by an automatic or manual system of component placing, like for example a Pick&Place machine. The perforation may preferably be made by laser and the printing of conductive tracks using the printing techniques and inks aforementioned.

The printed electric circuits are connected to the electronics for acquisition, control and processing of the signal generated by the sensors.

An embodiment further comprises electric components of said electric circuit deposited on the paper layer, in particular by printing, offset printing, rotogravure, flexography, rotary serigraphy, inkjet or spraying, for example resistors, capacitors, or others.

With regard to the wood profiles and derivatives the electronics is connected to the printed sensor by setting, in other words, by clamping of a metallic part on the extreme end of the sensor, where connections to the electronic components required to the acquisition and/or signal transmission are clamped or welded. For the laminate and compact products, the electronics is welded by conventional methods in the rear part of the product.

This hardware is thus located in the non visible part of the multilayer products, being protected by a box and/or encapsulant.

An embodiment comprises a recess for accommodating this electronic control unit connected to said electric circuit.

In another embodiment electric connections of said electric circuit are predicted for other integrated electric circuits in other products of wood profiles or derivatives, laminate or compact products.

This extension can be embedded in the remaining pieces that constitute, for example, the skirting boards, floor coatings or the profiles, which are also installed in the same zone of the building, but without integrated electronics. Thus, it is possible to extend circuits over one or more divisions through the interconnection between said pieces.

In an embodiment, in the case of the electric supply, the cable runs by the piece where the sensor is integrated and ends with a connector which makes the connection to the extension needed for its connection to the electric current of the building.

For the acquisition and transmission of signal various electronic components are integrated. The signal from the electric transducer enters the circuit of signal conditioning, in order to treat this signal, so that afterwards it can be read by the (ADC) analogical to digital converter. The signal after being digitalized (converted into digital), will be encapsulated in a dataframe and will be transmitted by the communication interface to another location where this data can be analysed, shown to the end user or serve as "inputs" for other devices. Data can be transmitted by wireless communication interfaces, such as WiFi and Bluetooth.

The signal transmission by a wireless network allows, namely in the case of flooding, sounding of an alarm, sending a text message to the mobile phone of the user of the skirting board or, for example, turning off the building's water supply. For the light emitters, the activation of sensor allows for example the activation of the LED, or another output unit that the user considers of interest, which can be previously defined.

The circuit power supply is preferably 5 V, the voltage being converted from the 220 VAC in continuous 5 V. This can be done, for example, through an induction circuit or by rectification of the AC signal.

The present solution thus concerns a fabrication process of wood derived multilayer products with an electric circuit including:

depositing conductive ink on a paper layer for obtaining a printed electric circuit including conductive elements;

arranging the paper layer with one or more electric circuits on a substrate of wood derivatives or on a multilayer structure constituted by papers which is subsequently subject to predefined pressure and temperature conditions;

connecting the printed circuit by clamping to the electronics for acquisition, control and/or signal processing;

optionally, integrating light emitters almost in an invisible way in the wood derived products.

**Brief Description of the Drawings**

The following figures provide preferred embodiments for illustrating the description and should not be seen as limiting the scope of invention.

Figure 1: Schematic representation of the printing technique by serigraphy.

Figure 2: Schematic representation of the fabrication process of the profiles.

Figure 3: Schematic representation of the profile with integrated flood sensor.

Figure 4: Representation of the integration of the sensor on a laminate product.

Figure 5: Representation of the integration of light emitters on laminate and compact products.

Figure 6: Schematic representation of the perforation of decorative papers, kraft paper, via laser, and connections.

Figure 7: Schematic representation of connections for the laminate products, compact products and for the profiles.

**Detailed Description**

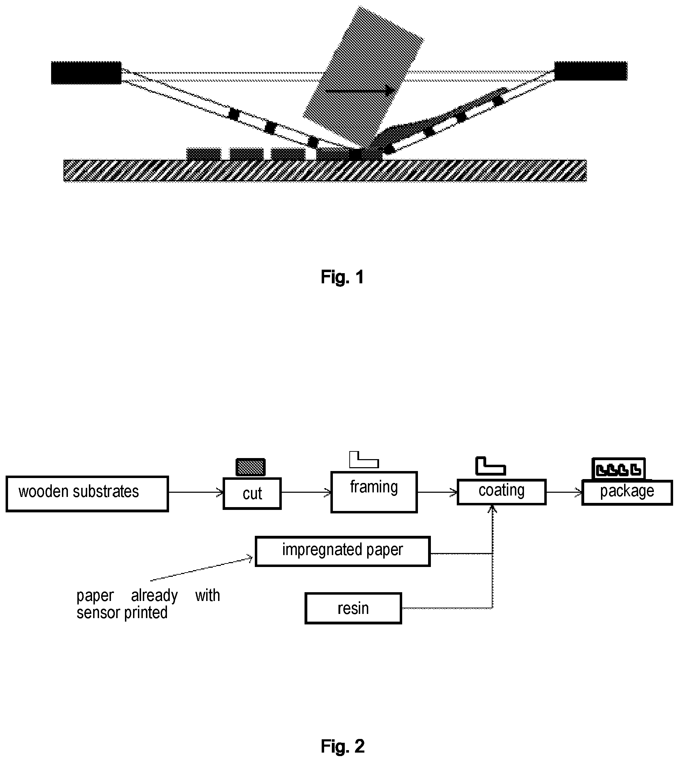

Figure 1 shows an embodiment of the printing process of the sensor and/or matrices, where the printing technique used is serigraphy. The raw material used is preferably silver based conductive ink. Briefly, in serigraphy, the ink is placed on a screen wherein a negative of the pattern which is intended to be printed is blocked, a squeegee being used in order to force the passage of ink through the regions of the screen that are not locked to the substrate. After printing the patterns are subjected to a thermal cure, according to the specifications of the ink.

Figure 2 shows an embodiment of the sensor's integration into the profile, namely in skirting boards and/or wood frames. The profiles are produced with substrates or wood derivatives and coated with decorative papers, namely through the gluing process at low pressure with thermo-adhesives applied by fusion or reactive polymers. In phase 1, the cutting phase, the substrate is chopped into strips according to the width of the profile and cut longitudinally. In phase 2, the framing phase, through the combination of the various cutting blade tools, the longitudinal thinning of the previous substrate strip is performed to give it the "outline" of the intended cross-profile. The achieved product is called a frame. Prior to stage 3, the coating stage, there is an intermediate cutting phase of the impregnated paper roll with sensorisation printed on the width which it is intended to coat the frame in. In step 3, the coating operation is executed all on a single machine, which consists of:

- gluing the paper with printed sensors, through a proper applicator, like for example by hot melt technology using thermal-adhesives or reactive polymers and under controlled temperature and humidity conditions;
- proceeding with the simultaneous advancement of the frame and glued paper;
- "adjusting", under pressure and temperature, the paper to the format of the frame profile, through at least two rollers of a polymeric material;
- stabilizing the gluing;
- cutting to length for fine tuning the final dimension.

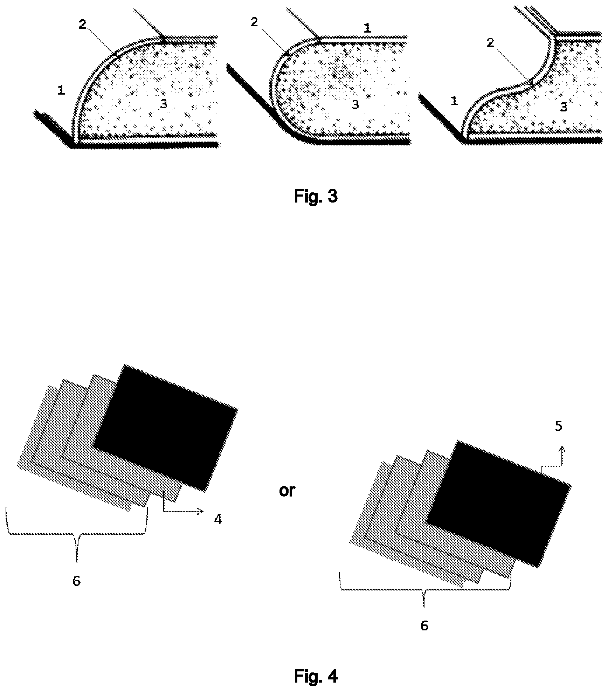

Figure 3 shows an embodiment of the integration of sensor 2 on the profile, in particular on skirting boards and/or wood frames, via the profile with sensor 2 integrated. Sensor 2 is printed on the decorative paper 1, on the face that is facing the substrate or wood derivative of the profile, in other words, of substrate 3. The sensor 2 is located on the exposed face of the profile.

Figure 4 shows an embodiment of the integration of the sensor on the laminate or compact product. Simply put, the laminate or compact products are produced using a set of sheets of paper impregnated with resin that after subject to high pressure and temperatures form a single product of high resistance. At the top of this set of sheets of paper an impregnated decorative paper 5 is placed and on the base various kraft paper sheets 6 are placed. The larger the number of kraft paper sheets used the higher the thickness of the final material. The thickness of the final product defines if this is a high pressure laminate (HPL) or a compact one. The sensor can be printed, by the techniques previously mentioned, on the face of the decorative paper that is not exposed to surface 5 or on the first sheet of kraft paper constituent of the laminate product 4. The remaining kraft paper sheets 6 are perforated, via laser, in order to expose the electrode of the sensor for connection to the electronics needed for signal acquisition and transmission. After being subject to the pressing the final aspect of this laminate product is identical to that of a laminate or compact product without integrated sensor.

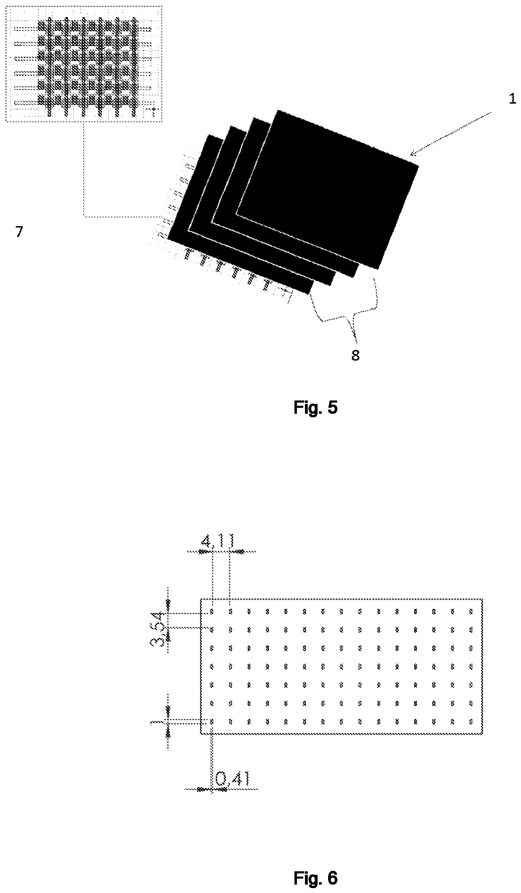

Figure 5 shows an embodiment of the integration of light emitters on the laminate and compact products, with decorative paper 1, with the first kraft with printing of a conductive matrix and placing of the light emitters 7, for example LEDs (light emitting diode), and with kraft paper perforated via laser in the LED area 8. Light emitters can be integrated, for example small dimension LEDs on the laminate and compact products, with the use of a Pick&Place machine and laser perforation of the subjacent papers for the component to resist to high pressure. After being subjected to pressing, the final aspect of this laminate product is identical to a laminate and/or compact product without an integrated light emitter.

Figure 6 shows an embodiment of the perforation of kraft papers, via laser, and connections. The perforation of kraft papers for placement of the light emitters is carried out in a precise way, according to the size of the LED used, in other words, length and width, via laser. With this perforation the LED is perfectly fitted in in the kraft papers, not being visible on the laminate product after the pressing test. This process is important so that the LED resists high pressure pressing. The same typology of process can be used for perforation of kraft paper on the sensor electrodes region for posterior connection to the electronics needed for signal processing.

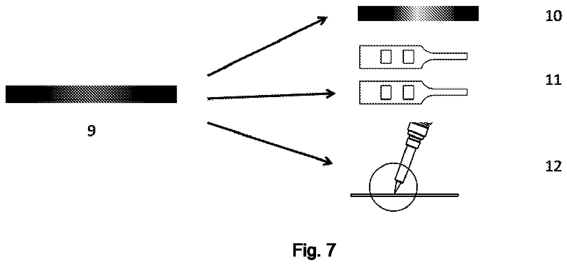

Figure 7 shows an embodiment of the connections, for the laminate products, compact products and/or profiles. The connections are made with the use of different types of connectors, so that the sensors and/or printed tracks 9 are not damaged. The connectors are used for driving the signal among the control system, the power supply and the sensors. For this purpose metallic connectors are used whose application can be performed by crimping 11 and/or welding 12 allowing a quick fit in, and/or conductive metallic strips 10 with adhesive properties whose application can be made by gluing, and/or conductive metallic wires fixed on the substrate by crimping 11, welding 12 or both. The same system of connectors is used to make the connection to external AC power systems, through the connections between integrated hardware DC (AC/DC converter) and conventional electric installation.

Example 1: Moisture/flooding detector profile. Within the scope of this technology, wood derived profiles or skirting boards can be developed capable of detecting moisture/flooding. The flood sensor consists of a interdigitated capacitive sensor printed on decorative paper in a roll-to-roll system by conventional printing techniques and with recourse to solvent based conductive inks. The decorative paper with printed sensorisation is glued by thermal-adhesives applied by fusion or reactive polymers to wood substrates (MDF or HDF, fibreboard) for the development of skirting board/profile capable of detecting the presence of water. On the face that is not exposed of the wood substrate a hole is made for fitting of the electronics for signal acquisition and processing. This includes a wireless communication system for sending alerts to the user in case of flooding or the increasing of the value read by the sensor for values superior to the previously defined. This system also allows a constant control by the end user, by consulting the signals read by the sensor on a database. This control and monitoring can be done on-site or remotely.

In an embodiment, for detecting floods, interdigitated capacitive sensors with two electrodes and system for signal acquisition and transmission thereof are integrated. This type of sensor allows the detection of the presence of water through the variation of the capacity of the condenser formed between the two electrodes. This sensor, in contact with water, by reaching a previously defined value sends an alert to the user, or to the mobile phone or to the computer and can also close the main water supply of the house, namely it can close doors and/or shutters, according to the user's interest. The communication of this control unit can be, for example, by Bluetooth, wireless network, with local alert, for example by use of domotics, or GSM (global system for mobile communications) or GPRS (General Packet Radio Service), with an alert from a distance, for example with the resort to a smartphone (smart phone).

Example 2: Laminate and compact products with integrated light emitters. Matrices or conductive tracks with inks on kraft paper are printed on roll-to-roll systems or on sheet-to-sheet systems. Small dimension light emitters on the cells that form the conductive matrix are integrated with resort to Pick&Place systems. Paper blocks for the development of laminate and compact products are built with the following characteristics from the base to the top:

- perforated kraft paper for the connection of the electronics to the conductive matrix;
- kraft paper with a printed conductive matrix and integrated light emitters;
- perforated kraft paper on the area of light emission;
- decorative paper.

This set is subject to high pressure and temperature conditions, giving way to a unique structure with high mechanical resistance. The final product is connected by cable to the electronic systems for the activation of the light emitters according to predefined patterns.

Example 3: Laminate and compact products with light emitters and integrated touch sensors. The light emitters of Example 2 can be activated by touch action on the surface of the laminate or compact product or profile or framed product. The touch sensor is printed on decorative or kraft paper with resort to roll-to-roll or sheet-to-sheet printing techniques with solvent based conductive inks. This decorative or kraft paper with printed sensorisation is an integrated part of the set of papers previously described for the development of laminate or compact products. The subjacent kraft papers are perforated for the connection to the signal acquisition and processing electronics. This entire set is subject to high pressure and temperatures conditions for the development of a unique structure and of high resistance. The laminate or compact products when subject to touch or approach to its surface activate the light emitters that are an integral part of its structure.

Example 4: kraft paper - kraft paper is a type of paper of high resistance with a cellulose base. Examples include papers for printing and writing; fabrics, coffee filters and other consumer products; and specialized applications, such as fibre cement and Japanese washi paper. A particular type of kraft paper used in this technology is referred to as of whitened soft wood, septentrional kraft or NBSK (northern bleached softwood) pulp. It is sought for its diversity of applications, and for its high strength, porosity and other functional advantages. As an example of kraft paper manufacturers the Catalyst Today's Paper, Gascogne Paper, Horizon Pulp and Paper Ltd can be considered, or for example other members of CEPI Eurokraft - European Association for kraft paper producers, for the Sack Paper Industry and kraft paper for packaging industries.

Example 5: Conductive ink - The printing ink used contains conductive materials, in particular silver, copper, nickel, carbon, graphite, platinum, polymeric materials, as for example PEDOT:PSS, among others. This ink should have good thermal and mechanical properties in order to withstand the conditions of the process. As an example of manufacturers and suppliers of this type of paint one can consider Heraeus Electronic Materials Division and Agfa.

The term "comprising" whenever used in this document is intended to indicate the presence of stated features, integers, steps, components, but not to preclude the presence or addition of one or more other features, integers, steps, components or groups thereof. It will be appreciated by those of ordinary skill in the art that unless otherwise indicated herein, the particular sequence of steps described is illustrative only and can be varied without departing from the disclosure. Thus, unless otherwise stated the steps described are so unordered meaning that, when possible, the steps can be performed in any convenient or desirable order.

The disclosure should not be seen in any way restricted to the embodiments described and a person with ordinary skill in the art will foresee many possibilities to modifications thereof. The above described embodiments are combinable. The following claims further set out particular embodiments of the disclosure.

## Claims

1. Wood derived multilayer glued or laminated product having an integrated electric circuit, comprising a paper layer and conducting elements of conductive ink deposited on said paper layer, said elements being suitable for forming an electric circuit and said paper layer has a rugosity inferior to 60 $\mu$m as measured using the method disclosed in the description, wherein the product is obtained by:

   depositing conductive ink on the paper layer, in a roll or sheet by sheet, to form said electric circuit including conducting elements;
   arranging the paper layer with at least one electric circuit under at least one further paper layer;
   pressing the paper layers together with the electric circuit paper layer;

   wherein the paper used in the multilayer product is kraft paper.

2. Product according to the previous claim comprising one or more additional kraft paper layers.

3. Product according to the previous claim wherein one or more of the additional kraft paper layers have a hole for receiving one or more electric components of the electric circuit such that the top surface of multilayer product is flat.

4. Product according to any of the previous claims comprising a fibreboard substrate, wherein said fibreboard is a MDF board, a HDF board or a particle board.

5. Product according to any of the previous claims wherein the thickness of the conductive elements of deposited conductive ink is below 20 $\mu$m.

6. Product according to any of the previous claims comprising one or more electric components clamped to one or more conducting elements of deposited conductive ink and the paper layer, or
   one or more electric components clamped to one or more conducting elements of deposited conductive ink and the paper layer, wherein the electric component is a metallic connector or a light emitter, or
   one or more deposited electric components contiguously connected to one or more of the conducting elements of deposited conductive ink, or
   one or more deposited electric components contiguously connected to one or more of the conducting elements of deposited conductive ink, wherein the electric component is a light emitter or a resistive sensor, in particular a carbon resistive sensor, a ceramic film resistive sensor, or a resistive sensor having a temperature coefficient.

7. Product according to any of the previous claims wherein the conducting elements of deposited conductive ink comprise two interdigitated finger electrodes for a capacitive sensor.

8. Product according to any of the previous claims comprising a recess for accommodating the electronic control unit, in particular the recess being in a substrate layer of said product.

9. Product according to any of the previous claims wherein the kraft paper is plain kraft paper, impregnated kraft paper, or kraft paper impregnated with phenolic resin.

10. Product according to any of the previous claims wherein the conductive ink is solvent based, aqueous based, or oil based and wherein the conductive ink comprises silver, copper, carbon, graphite, platinum, PEDOT:PSS, or combinations thereof.

11. Product according to any of the previous claims wherein the product is a compact product, laminate product, profile product or framed product.

12. Manufacture process of a wood derived multilayer glued or laminated product having an integrated electric circuit according to any claim 1-11, comprising the steps of:

   providing a paper layer having rugosity inferior to 60 $\mu$m as measured using the method disclosed in the description;
   depositing conducting elements of conductive ink on said paper layer, in a roll or sheet by sheet, for forming an electric circuit;
   arranging the paper layer with at least one electric circuit under at least one further paper layer;
   incorporating, by gluing or laminating, said electric circuit paper layer into the multilayer product by pressing the paper layers together with the electric circuit paper layer;
   wherein the paper used in the multilayer product is kraft paper.

13. Manufacture process according to claim 12 comprising the steps of:

   arranging the paper layer with deposited electric circuit on, or under, or between a plurality of additional paper layers;
   laminating all the paper layers onto a wood derived substrate.

14. Manufacture process according to the previous claim comprising drilling or cutting one or more holes in the additional paper layers in order to compensate for the relief caused by the electric circuit or by any component of the electric circuit, such that the top surface of the final multilayer product is flat, in particular wherein the cutting is by laser.

15. Manufacture process according to any one of claims 12-14 wherein the conductive ink is deposited by printing, offset printing, rotogravure, serigraphy, flexography, rotary serigraphy, inkjet or spraying.

**Patentansprüche**

1. Mehrschichtiges verleimtes oder laminiertes Produkt aus Holz mit einer integrierten elektrischen Schaltung, umfassend eine Papierschicht und leitende Elemente aus leitender Tinte, die auf die genannte Papierschicht aufgebracht werden, wobei die genannten Elemente geeignet sind, eine elektrische Schaltung zu bilden, und die genannte Papierschicht eine Rauheit von weniger als 60 $\mu$m aufweist, gemessen nach dem in der Beschreibung angegebenen Verfahren, wobei das Produkt wie folgt erhalten wird:

   Aufbringen von leitender Tinte auf der Papierschicht, in einer Rolle oder Blatt für Blatt, um die genannte elektrische Schaltung, einschließlich der leitenden Elemente zu bilden;
   Anbringen der Papierschicht mit mindestens einer elektrischen Schaltung unter mindestens einer weiteren Papierschicht;
   Zusammenpressen der Papierschichten mit der Papierschicht mit der elektrischen Schaltung;
   wobei das in dem mehrschichtigen Produkt verwendete Papier Kraftpapier ist.

2. Produkt nach dem vorangehenden Anspruch, umfassend eine oder mehrere zusätzliche Kraftpapierschichten.

3. Produkt nach dem vorangehenden Anspruch, wobei eine oder mehrere der zusätzlichen Kraftpapierschichten ein Loch zur Aufnahme einer oder mehrerer elektrischer Komponenten der elektrischen Schaltung aufweisen, sodass die obere Fläche des mehrschichtigen Produkts flach ist.

4. Produkt nach einem der vorangehenden Ansprüche, umfassend ein Faserplattensubstrat, wobei die genannte Faserplatte eine MDF-Platte, eine HDF-Platte oder eine Spanplatte ist.

5. Produkt nach einem der vorangehenden Ansprüche, wobei die Dicke der leitenden Elemente aus aufgebrachter leitender Tinte unter 20 $\mu$m liegt.

6. Produkt nach einem der vorangehenden Ansprüche, umfassend eine oder mehrere elektrische Komponenten, die an ein oder mehrere leitende Elemente aus aufgebrachter leitender Tinte und der Papierschicht angeklemmt sind, oder
   eine oder mehrere elektrische Komponenten, die an ein oder mehrere leitende Elemente aus aufgebrachter leitender Tinte und der Papierschicht angeklemmt sind, wobei die elektrische Komponente ein metallischer Steckverbinder oder ein Lichtemitter ist, oder ein oder mehrere aufgebrachte elektrische Komponenten, die zusammenhängend mit einem oder mehreren der leitenden Elemente aus der aufgebrachten leitenden Tinte verbunden sind, oder ein oder mehrere aufgebrachte elektrische Komponenten, die zusammenhängend mit einem oder mehreren der leitenden Elemente aus der aufgebrachten leitenden Tinte verbunden sind, wobei die elektrische Komponente ein Lichtemitter oder ein Widerstandssensor ist, insbesondere ein resistiver Sensor aus Kohlenstoff, ein resistiver Sensor aus einem Keramikfilm oder ein resistiver Sensor mit einem Temperaturkoeffizienten.

7. Produkt nach einem der vorangehenden Ansprüche, wobei die leitenden Elemente aus aufgebrachter leitender Tinte zwei ineinandergreifende Fingerelektroden für einen kapazitiven Sensor umfassen.

8. Produkt nach einem der vorangehenden Ansprüche, umfassend eine Aussparung zur Aufnahme der elektronischen Steuereinheit, wobei sich die Aussparung insbesondere in einer Substratschicht des genannten Produkts befindet.

9. Produkt nach einem der vorangehenden Ansprüche, wobei das Kraftpapier einfaches Kraftpapier, imprägniertes Kraftpapier oder mit Phenolharz imprägniertes Kraftpapier ist.

10. Produkt nach einem der vorangehenden Ansprüche, wobei die leitende Tinte auf Lösungsmittel, auf Wasser oder auf Öl basiert und wobei die leitende Tinte Silber, Kupfer, Kohlenstoff, Graphit, Platin, PEDOT:PSS oder Kombinationen davon umfasst.

11. Produkt nach einem der vorangehenden Ansprüche, wobei das Produkt ein kompaktes Produkt, ein laminiertes Produkt, ein Profilprodukt oder ein gerahmtes Produkt ist.

12. Herstellungsverfahren für ein aus Holz gefertigtes mehrschichtiges verleimtes oder laminiertes Produkt mit einer integrierten elektrischen Schaltung nach einem der Ansprüche 1-11, das folgende Schritte umfasst:

Bereitstellen einer Papierschicht mit einer Rauheit von weniger als 60 $\mu$m, gemessen nach dem in der Beschreibung angegebenen Verfahren;
Aufbringen leitender Elemente aus leitender Tinte auf der genannten Papierschicht, in einer Rolle oder Blatt für Blatt, um eine elektrische Schaltung zu bilden;
Anordnen der Papierschicht mit mindestens einer elektrischen Schaltung unter mindestens einer weiteren Papierschicht;
Einarbeiten durch Kleben oder Laminieren der genannten Papierschicht mit der elektrischen Schaltung in das mehrschichtige Produkt durch Zusammenpressen der Papierschichten und der Papierschicht mit der elektrischen Schaltung;
wobei das in dem mehrschichtigen Produkt verwendete Papier Kraftpapier ist.

13. Herstellungsverfahren nach Anspruch 12, das folgende Schritte umfasst:

Anordnen der Papierschicht mit der aufgebrachten elektrischen Schaltung auf oder unter oder zwischen mehreren zusätzlichen Papierschichten;
Laminieren aller Papierschichten auf ein aus Holz gewonnenes Substrat.

14. Herstellungsverfahren nach dem vorangehenden Anspruch, umfassend das Bohren oder Schneiden eines oder mehrerer Löcher in die zusätzlichen Papierschichten, um die durch die elektrische Schaltung oder durch eine Komponente der elektrischen Schaltung verursachte Erhebung auszugleichen, sodass die obere Fläche des mehrschichtigen Endprodukts flach ist, wobei das Schneiden insbesondere mittels Laser erfolgt.

15. Herstellungsverfahren nach einem der Ansprüche 12-14, wobei die leitende Tinte durch Drucken, Offsetdruck, Rotationstiefdruck, Serigraphie, Flexodruck, Rotationsserigraphie, Tintenstrahl oder Sprühen aufgebracht wird.

**Revendications**

1. Produit multicouche dérivé du bois collé ou laminé ayant un circuit électrique intégré, comprenant une couche de papier et d'éléments conducteurs d'encre conductrice déposés sur ladite couche de papier, lesdits éléments étant adaptés pour former un circuit électrique et ladite couche de papier ayant une rugosité inférieure à 60 $\mu$m telle que mesurée à l'aide du procédé décrit dans la description, dans lequel le produit est obtenu en:

déposant l'encre conductrice sur la couche de papier, en rouleau ou feuille par feuille, pour former ledit circuit électrique incluant les éléments conducteurs ;
arrangeant la couche de papier avec au moins un circuit électrique sous au moins une couche de papier supplémentaire ;
pressant les couches de papier avec la couche de papier de circuit électrique ;
dans lequel le papier utilisé dans le produit multicouches est du papier kraft.

2. Produit selon la revendication précédente comprenant une ou plusieurs couche(s) de papier kraft supplémentaire(s).

3. Produit selon la revendication précédente dans lequel une ou plusieurs des couches de papier kraft supplémentaires ont un trou pour accomoder un ou plusieurs composant(s) électrique(s) du circuit électrique tel que la surface supérieure du produit multicouche soit plate.

4. Produit selon l'une quelconque des revendications précédentes comprenant un substrat de panneau de fibre, dans lequel ledit panneau de fibre est un panneau de MDF, un panneau de HDF ou un panneau de particules.

5. Produit selon l'une quelconque des revendications précédentes dans lequel l'épaisseur des éléments conducteurs de l'encre conductrice déposée est inférieure à 20 $\mu$m.

6. Produit selon l'une quelconque des revendications précédentes comprenant un ou plusieurs composant(s) électrique(s) fixé(s) à un ou plusieurs éléments conducteurs de l'encre conductrice déposée et à la couche de papier, ou

un ou plusieurs composant(s) électrique(s) fixé(s) à un ou plusieurs élément(s) conducteur(s) de l'encre conductrice déposée et à la couche de papier, dans lequel le composant électrique est un connecteur métallique ou un émetteur de lumière, ou

un ou plusieurs composant(s) électrique(s) déposé(s) connecté(s) de manière contiguë à un ou plusieurs des éléments conducteurs de l'encre conductrice déposée, ou

un ou plusieurs composant(s) électrique(s) déposé(s) connecté(s) de manière contiguë à un ou plusieurs des éléments conducteurs de l'encre conductrice déposée dans lequel le composant électrique est un émetteur de lumière ou un capteur résistif, en particulier un capteur résistif de carbonne, un capteur résistif de film céramique, ou un capteur résistif ayant un coefficient de température.

7. Produit selon l'une quelconque des revendications précédentes dans lequel les éléments conducteurs de l'encre conductrice déposée comprennent deux électrodes en forme de doigt entrecroisés à titre de capteur capacitatif.

8. Produit selon l'une quelconque des revendications précédentes comprenant une cavité pour accommoder l'unité de contrôle électronique, la cavité étant en particulier dans une couche de substrat dudit produit.

9. Produit selon l'une quelconque des revendications précédentes dans lequel le papier kraft est du papier kraft simple, du papier kraft imprégné, ou du papier kraft imprégré avec de la résine phénolique.

10. Produit selon l'une quelconque des revendications précédentes dans lequel l'encre conductrice est à base de solvant, à base aqueuse, ou à base d'huile et dans lequel l'encre conductrice comprend de l'argent, du cuivre, du carbone, du graphite, du platine, du PEDOT :PSS, ou des combinaisons de ceux-ci.

11. Produit selon l'une quelconque des revendications précédentes dans lequel le produit est un produit compact, un produit laminé, un produit profilé ou un produit encadré.

12. Procédé de fabrication d'un produit dérivé du bois multicouche collé ou laminé, ayant un circuit électrique intégré selon l'une quelconque des revendications 1-11, comprenant les étapes de :

fournir une couche de papier ayant une rugosité inférieure à 60 $\mu$m telle que mesurée utilisant le procédé décrit dans la description ;
déposer les éléments conducteurs de l'encre conductrice sur ladite couche de papier, en rouleau ou feuille par feuille, pour former un circuit électrique ;
arranger la couche de papier avec au moins un circuit électrique sous au moins une couche de papier supplémentaire;
incorporer, en collant ou en laminant, ladite couche de papier de circuit électrique au produit multicouche en pressant les couches de papier avec la couche de papier de circuit électrique ;
dans lequel le papier utilisé dans le produit multicouche est du papier kraft.

13. Procédé de fabrication selon la revendication 12 comprenant les étapes de :

arranger la couche de papier avec le circuit électrique déposé sur, ou en dessous de, ou entre une pluralité de couches de papier supplémentaires ;
laminer toutes les couches de papier sur un substrat dérivé de bois.

14. Procédé de fabrication selon la revendication précédente comprenant le perçage ou découpage d'un ou de plusieurs trous dans les couches de papier supplémentaires de façon à compenser la décharge causée par le circuit électrique ou par l'un quelconque des composants du circuit électrique, tel que la surface supérieure du produit multicouche final soit plate, en particulier dans lequel le découpage se fait par lazer.

15. Procédé de fabrication selon l'une quelconque des revendications 12-14 dans lequel l'encre conductrice est déposée par impression, impression offset, rotogravure, sérigraphie, flexographie, sérigraphie rotative, jet d'encre ou pulvérisation.

**Fig. 1**

**Fig. 2**

**Fig. 3**

or

**Fig. 4**

**Fig. 5**

**Fig. 6**

**Fig. 7**

**REFERENCES CITED IN THE DESCRIPTION**

**Patent documents cited in the description**

- PT 1536065 E
- US 2003136494 A1
- GB 572267 A
- DE 202014003058 U1